# EUROPEAN PATENT SPECIFICATION

(11) **EP 2 300 839 B1**
(45) Date of publication and mention of the grant of the patent: **05.09.2012**
(21) Application number: 09784141.5
(22) Date of filing: 15.07.2009
(51) Int. Cl.: G01R 31/34, G01R 31/12

(54) **METHOD AND APPARATUS FOR MEASURING BEARING CURRENTS IN AN ELECTRICAL MACHINE**
VERFAHREN UND VORRICHTUNG ZUR MESSUNG VON LAGERSTRÖMEN IN EINER ELEKTRISCHEN MASCHINE
PROCÉDÉ ET APPAREIL DE MESURE DES COURANTS DE PALIERS DANS UNE MACHINE ÉLECTRIQUE

(30) Priority: 15.07.2008 FI 20080438
(43) Date of publication of application: 30.03.2011
(73) Proprietor: ABB OY, 00380 Helsinki (FI)
(72) Inventor: PEKOLA, Jari, FI-01390 Vantaa (FI); HARING, Tapio, FI-70100 Kuopio (FI); MÄKI-ONTTO, Petri, FI-02720 Espoo (FI)
(74) Representative: Korpelainen, Seppo Ilmari
(86) International application number: PCT/FI2009/000065
(87) International publication number: WO 2010/007203

(56) References cited:
- EP-A1- 1 406 365
- EP-A2- 0 510 795
- DE-A1- 3 821 241
- US-A- 4 238 733

## Description

### Field of the invention

The present invention relates to a method and apparatus for measuring bearing currents in an electrical machine. Especially, the invention relates to measuring the bearing currents by detecting the radio frequency (RF) signals that are generated by the electric discharges in the bearings of the machine.

### Background of the invention

Electrical discharges occur in the electrical machines for many reasons. The electrical discharges are harmful and they tend to damage the machine in different ways. Three main causes are partial discharges of the windings, the bearing currents and sparking of the commutator. All these phenomena have been thoroughly investigated and there have been many proposals how to prevent and/or how to detect them before the efficiency of the electrical machine has been deteriorated or before any part of the machine has been damaged totally.

There have been many approaches to utilize the RF signal detection when defining the appearance of the electric discharges. The RF signal detectors have been proposed for detecting the electric discharges that are caused e.g. by the loose or broken conductors in the windings, intermittent strand and turn shorts in the windings. Further there have been several proposals to find out the monitoring of brush arcing in the commutator of the DC machine.

The electric discharges and the RF signals are in direct connection with the windings and the commutators, respectively, where the reason of the discharges locates. E.g. the electric discharge and the RF signals are generated in commutator because of the wearing and ageing of the brushes.

In connection of the bearing currents the situation is more difficult. The bearing currents can not be measured in most of the cases, but other variables, like common mode current or voltage in the terminals of the motor, or the voltage over the bearing may be measured. In some cases even these variables are out of access. Further it is not certain if there occur harmful discharges in the bearings.

Published International Application WO 2007/106015 discloses a method for indicating an electric discharge in a bearing of an electric drive system. The detected RF signals are processed to estimate the electric discharge and the estimated electric discharge is indicated. While all the prior art solutions uses the RF signals when detecting electric discharges in connection of the electrical machine they have certain drawbacks to identify when the detected RF signal truly is connected to the electric discharge in question.

US Patent 4 238 733 discloses a system that monitors corona discharge in the slots of electrical machines. An antenna is placed close to the slot of the stator to detect the radio frequency signal that is generated by the corona discharge.

Published patent application DE 38 21 241 discloses a protection system where a thyristor isolating stage is inserted between the insulation measurement circuit of the circuit arrangement and the mains switch. The triggering unit of the isolation stage is controlled by a triggering control unit which is synchronised with the mains frequency and is connected to the insulation measurement circuit.

### Summary of the invention

The object of the invention is to create a new method , as defined in the independent claim 1, and apparatus , as defined in the independent claim 4, for measuring bearing currents in the electrical machines by detecting RF signals caused by the electric discharges.

Further aspects of the invention are defined in the dependent claims.

The present invention gives a reliable and exact data if the high frequency voltages that originate from the power electronic switches cause the sparking. This data is possible analyze and monitor accurately. Thus the phenomena and its progress during the life cycle of the machine can easily be observed and utilized when evaluating the condition and possible maintenance requirement of the machine.

### Brief description of the drawings

Further features and advantages of the present invention will become apparent from the following detailed description, taken in combination with the appended drawings, in which:
Fig. 1 schematically illustrates an embodiment of the invention;
Fig. 2 schematically illustrates another embodiment of the invention
Fig. 3 schematically illustrates an embodiment of the invention in connection of diagnostic device.

### Detailed description

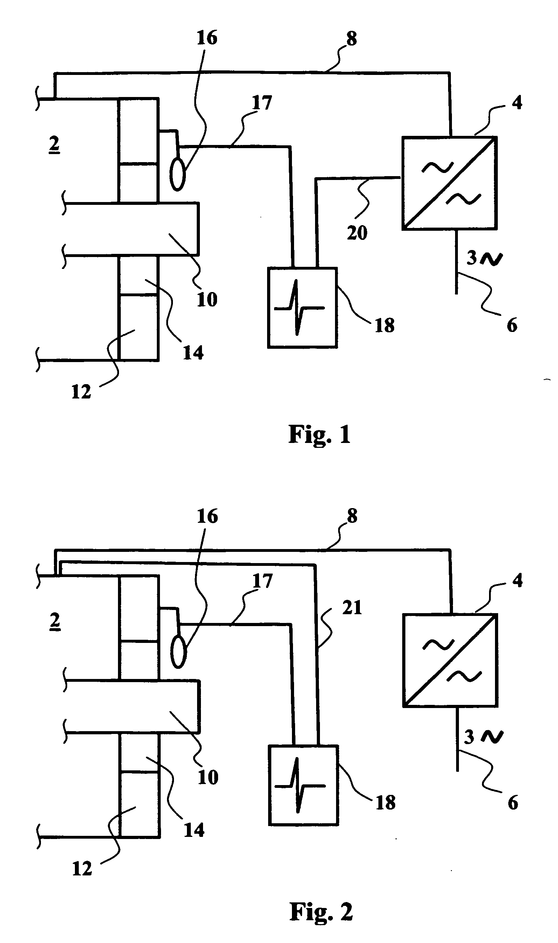

The Figure 1 schematically illustrates an embodiment of the invention. An electrical ac motor 2 is driven by frequency converter 4, which converts the ac main voltage supplied from the mains 6. The output of the frequency converter 4 is connected via the lines 8 to the terminals of the motor 2. The frequency converter 4 consists several electronic switches that are controlled by high frequency PWM pulses well known in the art.

The shaft 10 of the electric motor 2 is supported to the frame 12 of the motor by bearing 14. When the high frequency voltage pulses circulate in the stator of the motor they may under certain circumstances cause a high voltage pulse over the lubricant film of the bearing 14. If the voltage is high enough a bearing current flows through the bearing 14 causing an electric discharge. This phenomenon generates a radio frequency (RF) signal that can be detected by an antenna 16, which is placed near the bearing. The voltage in the output 17 of the antenna 16 can be monitored on the display of an oscilloscope 18. The magnitude of the bearing current that is proportional to the electric discharges can be measured. In order to get exact measurement result the trigger signals of the switches in the frequency converter 4 are conducted to the oscilloscope 18 via lines 20.

The Figure 2 illustrates another embodiment of the invention. In the Figure 2 the trigger signals of the oscilloscope 18 is taken from the terminals of the electric machine 2 via the lines 21. The trigger signals are thereby generated from sensors that measure the common mode voltage or the common mode current.

The antenna 16 is a loop antenna with several loops receiving RF signals. Other kind of antennas suitable for receiving RF signals can be used. The choice of the antenna depends on the measuring distance, too. The synchronizing signal can be any signal that is connected to the origin of the creation of the bearing currents. The idea is to get an exact timing signal of the switching frequency and this signal is used as a synchronizing signal when detecting the RF signal by the antenna. The noise signals can be reliably eliminated.

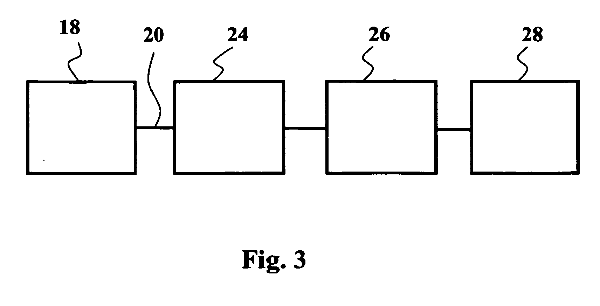

The Figure 3 illustrates the diagnostic device that utilizes the invention. The output 20 of the oscilloscope 18 triggered by the synchronizing signal is conducted to the analyzer 24. The intensity and the recurrence of the sparking are detected and registered in the registration module 26. The results are stored in the memory 28 continuously. The data is used when defining the service and maintenance.

The results of the measurement are further utilized by counting the discharge pulses by a pulse counter or integrator. This data is advantageously used to define a parameter proportional to the malfunction of the bearing.

The embodiments of the invention are described above are intended to be exemplary only. The scope of the invention is therefore intended to be limited solely by the scope of the appended claims.

## Claims

1. A method for measuring bearing currents in an electrical machine (2) driven by frequency converter (4), which consists of several electronic switches that are controlled by high frequency PWM pulses, wherein electric discharges are generated, which electrical machine (2) consists of a stator fixed to a frame (12) of the electrical machine and a rotor that is arranged to rotate around its axis (10) and is supported to the frame (12) by bearings (14), where the electric discharge bursts if the voltage over the lubricating film is high and the electric discharge generates a radio frequency signal, whereby radio frequency signals are detected continuously by an antenna (16) near the location of the electric discharge, **characterized in that** the method comprises the steps:
- a synchronizing signal is generated and being timely dependent to the origin of the discharge by conducting trigger signals of the switches in the frequency converter (4) to an oscilloscope (18) or, by conducting a common mode current or the common mode voltage measured by sensors to an oscilloscope (18),
- a radio frequency signal detecting equipment is triggered as a response to the synchronizing signal,
- the radio frequency signals that match to the synchronizing signal are registered as signal representing the bearing current.

2. Method according to the claim 1, **characterized in that** a time-window to be monitored is defined on the basis of the frequency of the synchronizing signal.

3. Method according to the claim 1 or 2, **characterized in that** the radio frequency signals are integrated or counted.

4. An apparatus for measuring bearing currents by monitoring electric discharges generated in an electrical machine (2) driven by frequency converter (4), which consists of several electronic switches that are controlled by high frequency PWM pulses, which machine consists of a stator fixed to a frame (12) of the electrical machine (2) and a rotor that is arranged to rotate around its axis (10) and is supported to the frame by bearings (14), whereby the electric discharge bursts over the bearing (14) if the voltage over the lubricant film is too high and the electric discharge generates a radio frequency signal, the apparatus comprising an antenna near the location of the electric discharge for continuously detecting the radio frequency signals, **characterized in that** the apparatus further comprises:
- a line (20) for conducting trigger signals of the switches in the frequency converter (4) to an oscilloscope (18), or a line (21) from the sensor detecting a common mode current or the common mode voltage to an oscilloscope (18), in order to generate a synchronizing signal that is timely dependent on and based to the origin of the discharge
- a detector (18) device that is triggered on the basis of synchronizing signal and
- a registration (24,26) component that displays or stores the radio frequency signals that match to the synchronizing signals.

5. Apparatus according to the claim 4, **characterized in that** the synchronizing signal is generated on the basis of the switching frequency of the converter (4) that controls the machine (2).

6. Apparatus according to any of the claims 4 or 5, **characterized in that** the oscilloscope (18) displays a voltage proportional to the bearing current.

7. Apparatus according to any of the claims 4 to 6, **characterized in that** the apparatus comprises a pulse counter or integrator to define a parameter proportional to the malfunction of the bearing.

## Patentansprüche

1. Verfahren zum Messen von Lagerströmen in einer elektrischen Maschine (2), die durch einen Frequenzwandler (4) angesteuert wird, der aus verschiedenen elektronischen Schaltern besteht, die durch Hochfrequenz-PWM-Impulse gesteuert werden, wobei elektrische Entladungen erzeugt werden, wobei die elektrische Maschine (2) aus einem Stator, der an einem Rahmen (12) der elektrischen Maschine befestigt ist, und einem Rotor, der dafür ausgelegt ist, sich um seine Achse (10) zu drehen, und an dem Rahmen (12) durch Lager (14) gestützt wird, besteht, wobei die elektrische Entladung stattfindet, wenn die Spannung über dem Schmierfilm hoch ist, und die elektrische Entladung ein Hochfrequenzsignal erzeugt, wobei Hochfrequenzsignale kontinuierlich durch eine Antenne (16) nahe der Stelle der elektrischen Entladung detektiert werden, **dadurch gekennzeichnet, dass** das Verfahren folgende Schritte umfasst:
- Erzeugen eines Synchronisierungssignals, das zeitlich vom Ursprung der Entladung abhängig ist, durch Einspeisen von Auslösesignalen der Schalter in dem Frequenzwandler (4) in ein Oszilloskop (18) oder durch Einspeisen eines Gleichtaktstromes oder einer Gleichtaktspannung, der bzw. die durch Sensoren gemessen wird, in ein Oszilloskop (18),
- Auslösen eines Hochfrequenzsignaldetektionsgerätes in Reaktion auf das Synchronisierungssignal,
- Registrieren der Hochfrequenzsignale, die zu dem Synchronisierungssignal passen, als ein Signal, das den Lagerstrom darstellt.

2. Verfahren nach Anspruch 1, **dadurch gekennzeichnet, dass** ein zu überwachendes Zeitfenster anhand der Frequenz des Synchronisierungssignals definiert wird.

3. Verfahren nach Anspruch 1 oder 2, **dadurch gekennzeichnet, dass** die Hochfrequenzsignale integriert oder gezählt werden.

4. Vorrichtung zum Messen von Lagerströmen durch Überwachen elektrischer Entladungen, die in einer elektrischen Maschine (2) erzeugt werden, die durch einen Frequenzwandler (4) angesteuert wird, der aus verschiedenen elektronischen Schaltern besteht, die durch Hochfrequenz-PWM-Impulse gesteuert werden, wobei die Maschine aus einem Stator, der an einem Rahmen (12) der elektrischen Maschine (2) befestigt ist, und einem Rotor, der dafür ausgelegt ist, sich um seine Achse (10) zu drehen, und an dem Rahmen durch Lager (14) gestützt wird, besteht, wobei die elektrische Entladung über dem Lager (14) stattfindet, wenn die Spannung über dem Schmierfilm zu hoch ist, und die elektrische Entladung ein Hochfrequenzsignal erzeugt, wobei die Vorrichtung eine Antenne nahe der Stelle der elektrischen Entladung umfasst, um die Hochfrequenzsignale kontinuierlich zu detektieren, **dadurch gekennzeichnet, dass** die Vorrichtung Folgendes umfasst:
- eine Leitung (20) zum Einspeisen von Auslösesignalen der Schalter in dem Frequenzwandler (4) in ein Oszilloskop (18) oder eine Leitung (21) von dem Sensor, der einen Gleichtaktstrom oder eine Gleichtaktspannung zu einem Oszilloskop (18) detektiert, um ein Synchronisierungssignal zu erzeugen, das zeitlich von der Entladung abhängig ist und auf deren Ursprung basiert,
- eine Detektorvorrichtung (18), die auf der Basis des Synchronisierungssignals ausgelöst wird, und
- eine Registrierungskomponente (24, 26), welche die Hochfrequenzsignale anzeigt oder speichert, die zu den Synchronisierungssignalen passen.

5. Vorrichtung nach Anspruch 4, **dadurch gekennzeichnet, dass** das Synchronisierungssignal anhand der Schaltfrequenz des Konverters (4), der die Maschine (2) steuert, erzeugt wird.

6. Vorrichtung nach einem der Ansprüche 4 oder 5, **dadurch gekennzeichnet, dass** das Oszilloskop (18) eine Spannung proportional zu dem Lagerstrom anzeigt.

7. Vorrichtung nach einem der Ansprüche 4 bis 6, **dadurch gekennzeichnet, dass** die Vorrichtung einen Impulszähler oder -integrator umfasst, um einen Parameter proportional zu einer Fehlfunktion des Lagers zu definieren.

## Revendications

1. Procédé pour mesurer des courants de palier dans une machine électrique (2) entraînée par un convertisseur de fréquence (4), se composant de plusieurs commutateurs électroniques qui sont commandés par des impulsions à modulation de largeur d'impulsion, PWM, à haute fréquence, dans lequel des décharges électriques sont générées, ladite machine électrique (2) se compose d'un stator fixé sur un châssis (12) de la machine électrique et d'un rotor qui est agencé pour tourner autour de son axe (10) et est supporté sur le châssis (12) par des paliers (14), dans lequel la décharge électrique jaillit si la tension sur le film de lubrification est élevée et la décharge électrique génère un signal de radiofréquence, de telle manière que des signaux de radiofréquence soient continuellement détectés par une antenne (16) à proximité de l'emplacement de la décharge électrique, **caractérisé en ce que** le procédé comprend les étapes de :
- un signal de synchronisation est généré et est dépendant dans le temps de l'origine de la décharge en conduisant des signaux de déclenchement des commutateurs dans le convertisseur de fréquence (4) à l'oscilloscope (18) ou en conduisant le courant de mode commun ou la tension de mode commun mesurée par des capteurs à un oscilloscope (18),
- un équipement de détection de signal de radiofréquence est déclenché en réponse au signal de synchronisation,
- les signaux de radiofréquence correspondant au signal de synchronisation sont enregistrés en tant que signal représentant le courant de palier.

2. Procédé selon la revendication 1, **caractérisé en ce qu'**une fenêtre de temps à surveiller est définie sur la base de la fréquence du signal de synchronisation.

3. Procédé selon la revendication 1 ou 2, **caractérisé en ce que** les signaux de radiofréquence sont intégrés ou comptés.

4. Appareil pour mesurer des courants de palier en surveillant des décharges électriques générées dans une machine électrique (2) entraînée par un convertisseur de fréquence (4), se composant de plusieurs commutateurs électroniques qui sont commandés par des impulsions à modulation de largeur d'impulsion, PWM, à haute fréquence, ladite machine se compose d'un stator fixé sur un châssis (12) de la machine électrique (2) et d'un rotor qui est agencé pour tourner autour de son axe (10) et est supporté sur le châssis par des paliers (14), de telle manière que la décharge électrique jaillisse sur le palier (14) si la tension sur le film de lubrification est trop élevée et la décharge électrique génère un signal de radiofréquence, l'appareil comprenant une antenne à proximité de l'emplacement de la décharge électrique pour détecter continuellement les signaux de radiofréquence, **caractérisé en ce que** l'appareil comprend en outre :
- une ligne (20) pour conduire des signaux de déclenchement des commutateurs dans le convertisseur de fréquence (4) à un oscilloscope (18), ou une ligne (21) du capteur détectant le courant de mode commun ou la tension de mode commun à un oscilloscope (18), afin de générer un signal de synchronisation qui dépend dans le temps de l'origine de la décharge et sur laquelle il est basé ;
- un dispositif de détection (18) qui est déclenché sur la base du signal de synchronisation, et
- un composant d'enregistrement (24, 26) qui affiche ou stocke les signaux de radiofréquence correspondant aux signaux de synchronisation.

5. Appareil selon la revendication 4, **caractérisé en ce que** le signal de synchronisation est généré sur la base de la fréquence de commutation du convertisseur (4) qui commande la machine (2).

6. Appareil selon l'une quelconque des revendications 4 ou 5, **caractérisé en ce que** dans lequel l'oscilloscope (18) affiche une tension proportionnelle au courant de palier.

7. Appareil selon l'une quelconque des revendications 4 à 6, **caractérisé en ce que** l'appareil comprend un compteur ou un intégrateur d'impulsions pour définir un paramètre proportionnel au dysfonctionnement du palier.
